# EUROPEAN PATENT APPLICATION

(11) **EP 4 425 577 A1**
(43) Date of publication of application: **04.09.2024**
(21) Application number: 22886900.4
(22) Date of filing: 21.10.2022
(51) Int. Cl.: H01L 31/05

(54) **PHOTOELECTRIC CONVERSION MODULE, PADDLE, AND METHOD FOR MANUFACTURING PHOTOELECTRIC CONVERSION MODULE**

(30) Priority: 29.10.2021 JP 2021177691
(71) Applicant: Idemitsu Kosan Co.,Ltd., Tokyo 100-8321 (JP)
(72) Inventor: HORIGUCHI, Kyohei, Tokyo 100-8321 (JP); HAMANO, Mikio, Tokyo 100-8321 (JP); NAKAMURA, Motoshi, Tokyo 100-8321 (JP)
(74) Representative: Hoffmann Eitle
(86) International application number: PCT/JP2022/039308
(87) International publication number: WO 2023/074573

(57) **Abstract**

Provided is a photoelectric conversion module capable of connecting photoelectric conversion elements with stable connection strength. The photoelectric conversion module (100) comprises a first photoelectric conversion element (10a), a second photoelectric conversion element (10b) and a connector (200). The first photoelectric conversion element (10a) and the second photoelectric conversion element (10b) are arranged side by side so as to partially overlap each other. The connector (200) is connected to the first photoelectric conversion element (10a) at a first connection portion (210). The connector (200) is connected to the second photoelectric conversion element (10b) at a second connection portion (10b) away from the first connection portion (10a).

## Description

### Technical Field

The present invention relates to a photoelectric conversion module, a paddle, and a method for manufacturing a photoelectric conversion module.

### Background Art

Photoelectric conversion modules that convert light energy into electrical energy are known (Patent Literature 1). The photoelectric conversion module described in Patent Literature 1 includes a plurality of photoelectric conversion elements. End portions of the photoelectric conversion elements adjacent to each other are overlapped with each other. The photoelectric conversion elements adjacent to each other are electrically connected to each other by a conductor such as solder in a region overlapping each other (see Fig. 5 of Patent Literature 1).

### Citation List

### Patent Literature

Patent Literature 1: JP 2016-119401 A

### Summary

An overlapping region (non-power generation region) between photoelectric conversion elements adjacent to each other is preferably as narrow as possible. However, when the overlapping region is narrow, the area of a conductor such as solder connecting the photoelectric conversion elements is reduced, and thus connection strength may be reduced. For example, in a photoelectric conversion module for a mobile object such as space, air or a vehicle, a load such as vibration applied to the mobile object may apply a large load to a connection portion between the photoelectric conversion elements.

Therefore, a photoelectric conversion module capable of connecting photoelectric conversion elements with stable connection strength and a method for manufacturing the photoelectric conversion module are desired.

A photoelectric conversion module according to one aspect comprises: a first photoelectric conversion element; a second photoelectric conversion element; and a connector. The first photoelectric conversion element and the second photoelectric conversion element are arranged side by side so as to partially overlap each other. The connector is connected to the first photoelectric conversion element at a first connection portion. The connector is connected to the second photoelectric conversion element at a second connection portion away from the first connection portion.

A method for manufacturing a photoelectric conversion module comprises: a step of preparing a first photoelectric conversion element, a second photoelectric conversion element, and a connector; a step of connecting the connector to the first photoelectric conversion element at a first connection portion; a step of arranging the first photoelectric conversion element and the second photoelectric conversion element side by side so as to partially overlap each other; and a step of connecting the connector to the second photoelectric conversion element at a second connection portion away from the first connection portion.

A paddle according to one aspect comprises said photoelectric conversion module.

### Brief Description of Drawings

Fig. 1 is a schematic plan view of a photoelectric conversion module according to a first embodiment.
Fig. 2 is a schematic side view of the photoelectric conversion module according to the first embodiment as viewed from a Y direction in Fig. 1.
Fig. 3 is a schematic plan view of each photoelectric conversion element constituting the photoelectric conversion module.
Fig. 4 is a schematic plan view of a connector connecting photoelectric conversion modules adjacent to each other.
Fig. 5 is a schematic view for explaining a region of an insulator of the connector.
Fig. 6 is a schematic view for explaining one step in a method for manufacturing the photoelectric conversion module.
Fig. 7 is a schematic view for explaining a step following the step illustrated in Fig. 6.
Fig. 8 is a schematic plan view of a connector for connecting adjacent photoelectric conversion modules according to a second embodiment.
Fig. 9 is a schematic view for explaining a region of an insulator of the connector according to a second embodiment.
Fig. 10 is a schematic side view of a photoelectric conversion module according to a third embodiment.
Fig. 11 is a schematic plan view of a connector included in a photoelectric conversion module according to a fourth embodiment.
Fig. 12 is a schematic plan view of each photoelectric conversion element constituting a photoelectric conversion module according to a fifth embodiment.
Fig. 13 is a schematic plan view of a photoelectric conversion module according to a sixth embodiment.
Fig. 14 is a schematic perspective view of an artificial satellite including a photoelectric conversion module.

### Description of Embodiments

Hereinafter, embodiments will be described with reference to the drawings. In the following drawings, the same or similar parts are denoted by the same or similar reference numerals. However, it should be noted that the drawings are schematic, and ratios of dimensions and the like may be different from actual ones.

### [First Embodiment]

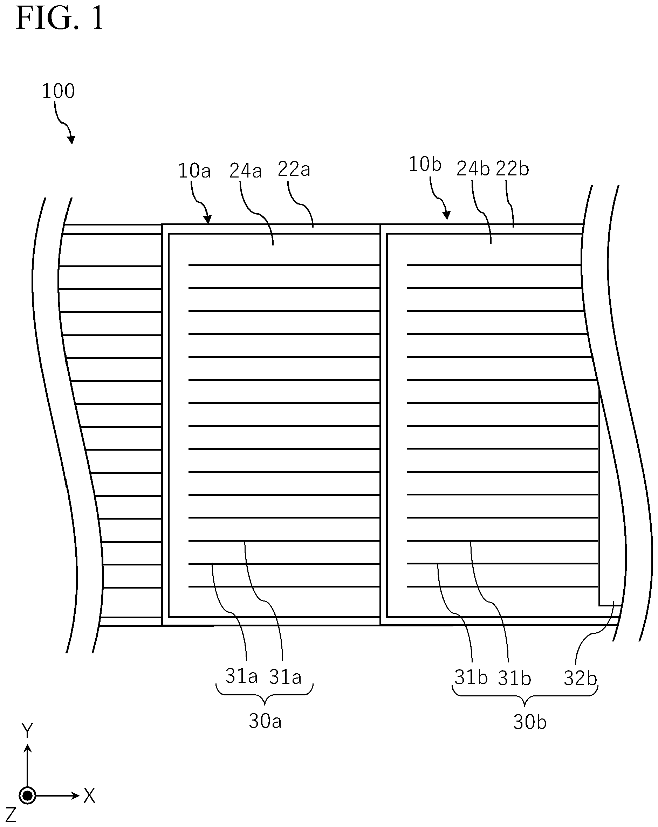

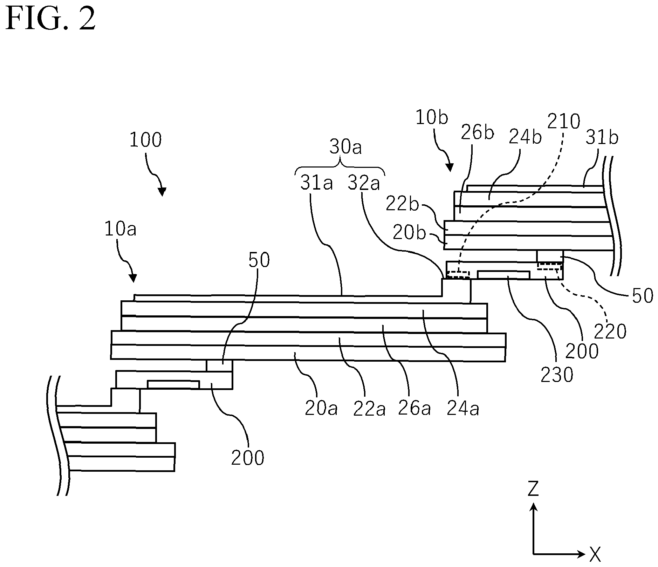

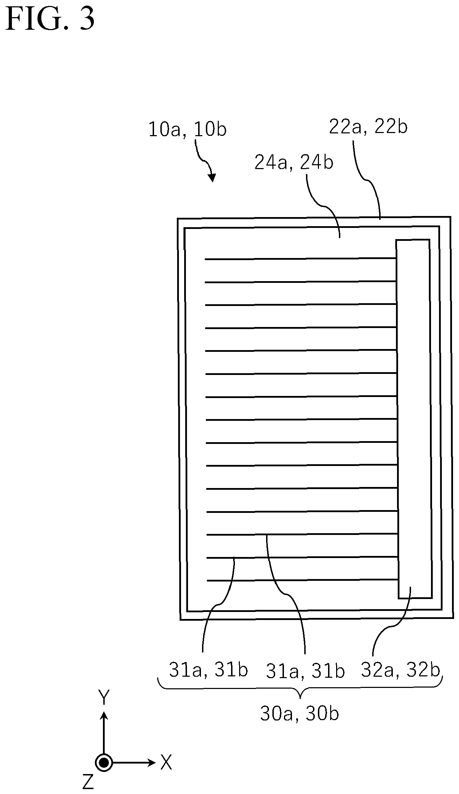

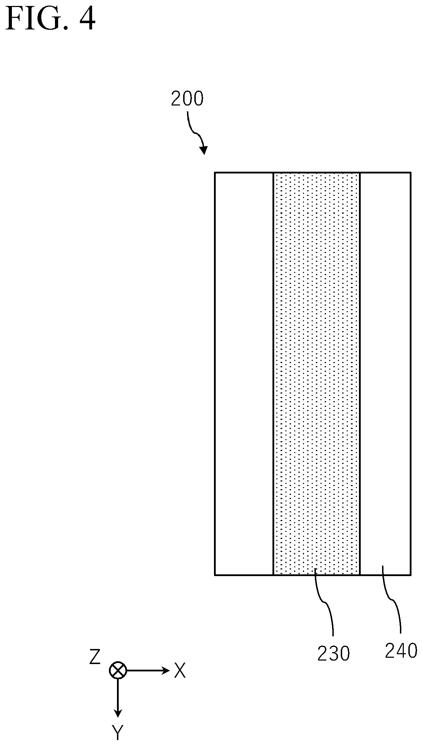

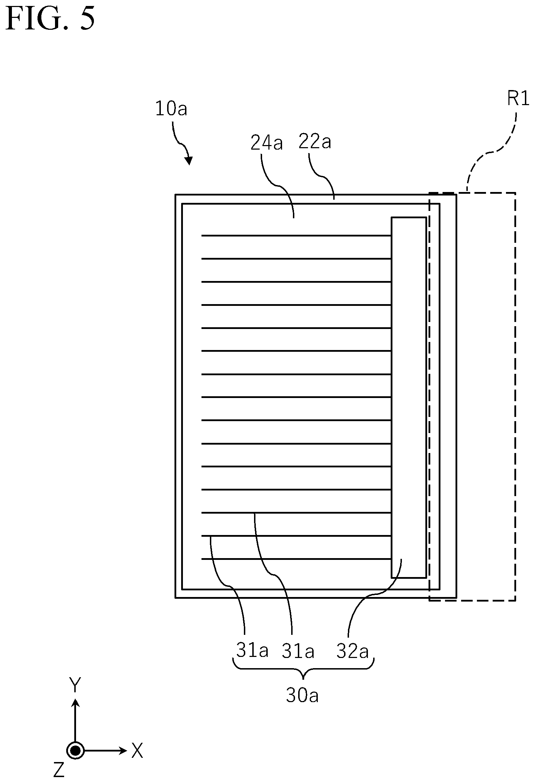

Fig. 1 is a schematic plan view of a photoelectric conversion module according to a first embodiment. Fig. 2 is a schematic side view of the photoelectric conversion module according to the first embodiment as viewed from a Y direction in Fig. 1. Fig. 3 is a schematic plan view of each photoelectric conversion element constituting the photoelectric conversion module. Fig. 4 is a schematic plan view of a connector connecting photoelectric conversion modules adjacent to each other. Fig. 4 illustrates one surface of the connector facing a first photoelectric conversion element 10a described later. Fig. 5 is a schematic view for explaining a region of an insulator of the connector. Note that, in Fig. 3, in order to describe the structure of each photoelectric conversion element constituting the photoelectric conversion module, reference numerals related to each photoelectric conversion element are attached.

A photoelectric conversion module 100 according to the first embodiment includes a plurality of photoelectric conversion elements 10a and 10b, and a connector 200 that electrically connects the photoelectric conversion elements 10a and 10b adjacent to each other. The plurality of photoelectric conversion elements 10a and 10b is arranged side by side in one direction (X direction in the drawing). The photoelectric conversion elements 10a and 10b adjacent to each other are provided side by side so as to partially overlap each other. Specifically, one end portions of the photoelectric conversion elements 10a and 10b overlap the other end portions of the photoelectric conversion elements 10a and 10b adjacent thereto in a thickness direction. The photoelectric conversion elements 10a and 10b adjacent to each other are electrically connected to each other by the connector 200 in the overlapping portion. The number of photoelectric conversion elements 10a and 10b arranged in one direction may be at least two, and preferably three or more.

The photoelectric conversion elements 10a and 10b according to the first embodiment may be thin-film photoelectric conversion elements. Preferably, the photoelectric conversion elements 10a and 10b are solar cell elements that convert light energy into electrical energy.

Each of the photoelectric conversion elements 10a and 10b has conductive substrates 20a and 20b serving as bases for forming respective layers such as first electrode layers 22a and 22b described later. The conductive substrates 20a and 20b are constructed by a substrate such as a metal substrate. Further, the conductive substrates 20a and 20b may be flexible substrates. The shapes and dimensions of the conductive substrates 20a and 20b are appropriately determined according to the sizes and the like of the photoelectric conversion elements 10a and 10b.

When a metal substrate is adopted as the conductive substrates 20a and 20b, the conductive substrates 20a and 20b are formed by, for example, titanium (Ti), stainless steel (SUS), copper or aluminum, or an alloy thereof, and so on. Alternatively, the conductive substrates 20a and 20b may have a laminated structure in which a plurality of metal base materials are laminated, and for example, a stainless foil, a titanium foil, or a molybdenum foil may be formed on the surface of the substrate. In order to prevent warpage, a metal material such as molybdenum, titanium, or chromium may be deposited on the back side of the conductive substrates 20a and 20b.

When the conductive substrates 20a and 20b are flexible metal substrates, the photoelectric conversion elements 10a and 10b can be bent, and cracking of the conductive substrates 20a and 20b can also be suppressed due to bending. Furthermore, in the above case, it is easy to reduce the weight and thickness of the photoelectric conversion module 100 as compared with a glass substrate.

The photoelectric conversion elements 10a and 10b may include at least first electrode layers 22a and 22b, second electrode layers 24a and 24b, and photoelectric conversion layers 26a and 26b provided between the first electrode layers 22a and 22b and the second electrode layers 24a and 24b. The photoelectric conversion layers 26a and 26b are layers that contribute to mutual conversion of light energy and electric energy. In a solar cell element that converts light energy into electric energy, the photoelectric conversion layers 26a and 26b may be referred to as light absorption layers.

The first electrode layers 22a and 22b and the second electrode layers 24a and 24b are adjacent to the photoelectric conversion layers 26a and 26b. In the present specification, the term "adjacent" shall mean not only that both layers are in direct contact, but also that both layers are in proximity via another layer.

The first electrode layers 22a and 22b are provided between the photoelectric conversion layers 26a and 26b and the conductive substrates 20a and 20b. The second electrode layers 24a and 24b are located on the side opposite to the conductive substrates 20a and 20b with respect to the photoelectric conversion layers 26a and 26b. Therefore, the photoelectric conversion layers 26a and 26b are located between the first electrode layers 22a and 22b and the second electrode layers 24a and 24b. The first electrode layers 22a and 22b are connected to the conductive substrates 20a and 20b.

In the present embodiment, the second electrode layers 24a and 24b may be constituted by transparent electrode layers. When the second electrode layers 24a and 24b are formed by transparent electrode layers, light incident on the photoelectric conversion layers 26a and 26b or is emitted from the photoelectric conversion layers 26a and 26b passes through the second electrode layers 24a and 24b.

When the second electrode layers 24a and 24b are formed by transparent electrode layers, the first electrode layers 22a and 22b may be formed by opaque electrode layers or may be formed of transparent electrode layers. The first electrode layers 22a and 22b may be formed by, for example, a metal such as molybdenum, titanium or chromium. Although not particularly limited, the thickness of the first electrode layers 22a and 22b may be, for example, 50 nm to 1500 nm.

As a preferred example, the second electrode layers 24a and 24b may be formed by an n-type semiconductor, more specifically, a material having n-type conductivity and relatively low resistance. The second electrode layers 24a and 24b can also function as an n-type semiconductor and a transparent electrode layer. The second electrode layers 24a and 24b include, for example, a metal oxide to which a group III element (B, Al, Ga, or In) is added as a dopant. Examples of the metal oxide include ZnO and SnO₂. The second electrode layer 24 can be selected from, for example, indium tin oxide (In₂O₃:Sn), indium titanium oxide (In₂O₃:Ti), indium zinc oxide (In₂O₃:Zn), tin zinc-doped indium oxide (In₂O₃:Sn, Zn), tungsten-doped indium oxide (In₂O₃:W), hydrogen-doped indium oxide (In₂O₃:H), indium gallium zinc oxide (InGaZnO₄), zinc tin oxide (ZnO:Sn), fluorine-doped tin oxide (SnO₂:F), gallium-doped zinc oxide (ZnO:Ga), boron-doped zinc oxide (ZnO:B), aluminum-doped zinc oxide (ZnO:Al), and the like.

Although not particularly limited, the thickness of the second electrode layers 24a and 24b is, for example, 0.5 um to 2.5 µm.

The photoelectric conversion layers 26a and 26b may include, for example, a p-type semiconductor. In a specific example, the photoelectric conversion layers 26a and 26b may function as, for example, a polycrystalline or microcrystalline p-type compound semiconductor layer. Although not particularly limited, the thickness of the photoelectric conversion layers 26a and 26b is, for example, 1.0 um to 3.0 um.

In a specific example, the photoelectric conversion layers 26a and 26b are formed by a chalcogen semiconductor containing a chalcogen element, and function as a polycrystalline or microcrystalline p-type compound semiconductor layer. The photoelectric conversion layers 26a and 26b may be made of, for example, a group I-III-VI₂ compound semiconductor having a chalcopyrite structure containing a group I element, a group III element and a group VI element (chalcogen element). Here, the group I element can be selected from copper (Cu), silver (Ag) gold (Au) and the like. The group III element can be selected from indium (In), gallium (Ga), aluminum (Al) and the like. In addition, the photoelectric conversion layers 26a and 26b may contain tellurium (Te) or the like in addition to selenium (Se) and sulfur (S) as the group VI element. In addition, the photoelectric conversion layers 26a and 26b may contain alkali metals such as Li, Na, K, Rb and Cs.

Alternatively, the photoelectric conversion layers 26a and 26b may be made of a group I₂-(II-IV)-VI₄ compound semiconductor which is a CZTS-based chalcogen semiconductor containing Cu, Zn, Sn, S or Se. Representative examples of the CZTS-based chalcogen semiconductor include those using a compound such as Cu₂ZnSnSe₄ or Cu₂ZnSn(S,Se)₄.

The photoelectric conversion layers 26a and 26b are not limited to those described above, and may be made of any material that causes photoelectric conversion.

The photoelectric conversion elements 10a and 10b may include a first buffer layer (not illustrated) between the photoelectric conversion layers 26a and 26b and the first electrode layers 22a and 22b if necessary. The first buffer layer may be a semiconductor material having the same conductivity type as the first electrode layers 22a and 22b, or may be a semiconductor material having a different conductivity type. The first buffer layer may be made of a material having higher electric resistance than the first electrode layers 22a and 22b.

The first buffer layer is not particularly limited, but may be, for example, a layer containing a chalcogenide compound of a transition metal element having a layered structure. Specifically, the first buffer layer may be made of a compound including a transition metal material such as Mo, W, Ti, V, Cr, Nb or Ta and a chalcogen element such as O, S or Se. The first buffer layer may be, for example, Mo(Se,S)₂ layer, a MoSe₂ layer, MoS₂ layer, or the like.

The photoelectric conversion elements 10a and 10b may include a second buffer layer (not illustrated) between the photoelectric conversion layers 26a and 26b and the second electrode layers 24a and 24b if necessary. In this case, the second buffer layer may be a semiconductor material having the same conductivity type as the second electrode layers 24a and 24b, or may be a semiconductor material having a different conductivity type. The second buffer layer may be made of a material having higher electric resistance than the second electrode layers 24a and 24b. The second buffer layer is formed on the photoelectric conversion layers 26a and 26b. Although not particularly limited, the thickness of the second buffer layer is, for example, 10 nm to 100 nm.

The second buffer layer can be selected from compounds containing zinc (Zn), cadmium (Cd) and indium (In). Examples of the compound containing zinc include ZnO, ZnS, Zn(OH)₂, or Zn(O,S) and Zn(O,S,OH) which are mixed crystals thereof, and further include ZnMgO and ZnSnO. Examples of the compound containing cadmium include CdS, CdO, or Cd(O,S) and Cd(O,S,OH) which are mixed crystals of CdS and CdO. Examples of the compound containing indium include In₂S₃ and In₂O₃, or In₂(O,S)₃ and In₂(O,S,OH)₃ which are mixed crystals of In₂S₃ and In₂O₃, and In₂O₃, In₂S₃, In(OH)ₓ, and the like can be used. The second buffer layer may have a laminated structure of these compounds.

The second buffer layer has an effect of improving characteristics such as photoelectric conversion efficiency, but this can be omitted. When the second buffer layer is omitted, the second electrode layers 24a and 24b are formed directly on the photoelectric conversion layers 26a and 26b.

It should be noted that the laminated structure of the photoelectric conversion elements 10a and 10b is not limited to the above aspect, and may take various aspects. For example, the photoelectric conversion elements 10a and 10b may have a configuration in which both an n-type semiconductor and a p-type semiconductor are sandwiched between the first electrode layer and the second electrode layer. In this case, the second electrode layer may not be made of the n-type semiconductor. In addition, the photoelectric conversion elements 10a and 10b are not limited to the p-n coupling type structure, and may have a p-i-n coupling type structure including an intrinsic semiconductor layer (i-type semiconductor) between an n-type semiconductor and a p-type semiconductor.

The photoelectric conversion elements 10a and 10b include collector electrodes 30a and 30b connected to the second electrode layers 24a and 24b, respectively. The collector electrodes 30a and 30b collect charge carriers from the second electrode layers 24a and 24b, and are formed by a conductive material. The collector electrodes 30a and 30b may be in direct contact with the second electrode layers 24a and 24b. From the viewpoint of securing a power-generatable region, the areas of the collector electrodes 30a and 30b are preferably as small as possible.

The collector electrodes 30a and 30b may have a plurality of substantially linear first portions 31a and 31b and second portions 32a and 32b connected to the plurality of first portions 31a and 31b. The first portions 31a and 31b may be referred to as "fingers". The second portions 32a and 32b may be referred to as "bus bars".

The first portions 31a and 31b are arranged each other at intervals. The first portions 31a and 31b have a function of guiding electric energy (charge carriers) generated in the photoelectric conversion layers 26a and 26b to the second portions 32a and 32b.

In the illustrated aspect, the substantially linear first portions 31a and 31b extend straight along one direction (X direction in the drawing). Alternatively, the first portions 31a and 31b may extend in a wavy line shape or a zigzag polygonal line shape. In the present specification, the term "linear" is defined by a concept including not only a straight line but also an elongated curved line such as a wavy line or a polygonal line.

The plurality of the first portions 31a and 31b of the collector electrodes 30a and 30b may be provided side by side in a first direction (Y direction in the drawing). The plurality of linear first portions 31a and 31b may be connected to the same second portions 32a and 32b. The plurality of first portions 31a and 31b may be provided on one side with respect to the second portions 32a and 32b.

The second portions 32a and 32b of the collector electrodes 30a and 30b may extend along the first direction (Y direction in the drawing). The second portions 32a and 32b may be connected to the first portions 31a and 31b at the end portions of the first portions 31a and 31b. In this case, the plurality of first portions 31a and 31b may extend from the second portions 32a and 32b along a second direction (X direction in the drawing).

The second portions 32a and 32b of the collector electrodes 30a and 30b may extend substantially from the vicinity of one end to the vicinity of the other end of the photoelectric conversion elements 10a and 10b in the first direction (Y direction in the drawing). A width W1 (width in the X direction in the drawing) of the second portions 32a and 32b of the collector electrodes 30a and 30b may be larger than the width (width in the Y direction in the drawing) of the first portions 31a and 31b.

The collector electrodes 30a and 30b (first portions 31a and 31b and second portions 32a and 32b) may be made of a material having higher conductivity than the material constituting the second electrode layers 24a and 24b. As a material constituting the collector electrodes 30a and 30b (first portions 31a and 31b and second portions 32a and 32b), a material having good conductivity and capable of obtaining high adhesion to the second electrode layers 24a and 24b is applied. For example, the material constituting the collector electrodes 30a and 30b can be selected from at least one of indium tin oxide (In₂O₃:Sn), indium titanium oxide (In₂O₃:Ti), indium zinc oxide (In₂O₃:Zn), tin zinc-doped indium oxide (In₂O₃:Sn,Zn), tungsten-doped indium oxide (In₂O₃:W), hydrogen-doped indium oxide (In₂O₃:H), indium gallium zinc oxide (InGaZnO₄), zinc tin oxide (ZnO:Sn), fluorine-doped tin oxide (SnO₂:F), aluminum-doped zinc oxide (ZnO:Al), boron-doped zinc oxide (ZnO:B), gallium-doped zinc oxide (ZnO:Ga), Ni, Ti, Cr, Mo, Al, Ag, and Cu, or a compound containing one or more of these. The collector electrodes 30a and 30b may be made of an alloy or a laminate made of a combination of the above-described materials.

The second portions 32a and 32b of the collector electrodes 30a and 30b are provided near one end portions of the photoelectric conversion elements 10a and 10b in plan view as viewed from a direction orthogonal to the photoelectric conversion surface (see Fig. 3). The second portions 32a and 32b of the collector electrodes 30a and 30b extend in the Y direction in the drawing along one end portion of the photoelectric conversion elements 10a and 10b at the one end portion.

The connector 200 mechanically and electrically connects the photoelectric conversion elements 10a and 10b adjacent to each other. The connector 200 may include a conductive member 240. The connector 200 may be, for example, a ribbon wire of a conductive metal including Ag, Ni, Co, Fe, Cr, Mo, Mn, Cu, Al, Ti, or a combination thereof. Furthermore, the connector 200 may be made of an alloy containing some of the above-described conductive metals, such as an alloy Kovar or stainless steel (SUS).

Next, a structure related to connection between the photoelectric conversion elements 10a and 10b will be described. Hereinafter, one of the photoelectric conversion elements 10a and 10b adjacent to each other may be referred to as a "first photoelectric conversion element", and the other of the photoelectric conversion elements 10a and 10b adjacent to each other may be referred to as a "second photoelectric conversion element". In the illustrated aspect, among the two photoelectric conversion elements adjacent to each other, the photoelectric conversion element 10a on the left side in the drawing is referred to as the "first photoelectric conversion element", and the photoelectric conversion element 10b on the right side in the drawing is referred to as the "second photoelectric conversion element". However, it should be noted that the terms the "first photoelectric conversion element" and the "second photoelectric conversion element" are merely used for convenience to distinguish the elements. Each of the first photoelectric conversion element and the second photoelectric conversion element may have the structure of the photoelectric conversion elements 10a and 10b described above. Therefore, the first photoelectric conversion element and the second photoelectric conversion element may be elements having the same structure.

The connector 200 is connected to the first photoelectric conversion element 10a at a first connection portion 210. The connector 200 may be connected to, for example, the collector electrode 30a of the first photoelectric conversion element 10a or a connection pad (not illustrated) provided in the collector electrode 30a of the first photoelectric conversion element 10a at the first connection portion 210. In the aspect illustrated in Fig. 2, the connector 200 is directly connected to the second portion 32a of the collector electrode 30a of the first photoelectric conversion element 10a at the first connection portion 210. Alternatively, the connector 200 may be connected to the second portion 32a of the collector electrode 30a of the first photoelectric conversion element 10a via a connection pad (not illustrated) at the first connection portion 210.

The connector 200 is connected to the second photoelectric conversion element 10b at a second connection portion 220 away from the first connection portion 210. For example, the connector 200 may be connected to the conductive substrate 20b of the second photoelectric conversion element 10b or the connection pad 50 provided on the conductive substrate 20b of the second photoelectric conversion element 10b. In the aspect illustrated in Fig. 2, the connector 200 is connected to the connection pad 50 provided on the conductive substrate 20b of the second photoelectric conversion element 10b at the second connection portion 220. Alternatively, the connector 200 may be directly connected to the conductive substrate 20b of the second photoelectric conversion element 10b at the second connection portion 220. The connection pad 50 may be, for example, a metal film such as aluminum. In this case, the material constituting the connection pad 50 and the material constituting the connector 200 are mutually diffused with heat generated at the time of connection, whereby the connector 200 can be more firmly connected.

The length of the connector 200 in an arrangement direction (X direction in the drawing) in which the first photoelectric conversion element 10a and the second photoelectric conversion element 10b are arranged may be smaller than the length of the second photoelectric conversion element 10b in the arrangement direction. As a result, the connector 200 is provided in a region covered with the second photoelectric conversion element 10b as viewed in the thickness direction. For example, the connector 200 may extend from the region of the second portion 32a of the collector electrode 30a of the first photoelectric conversion element 10a toward the side opposite to the first portion 31a with respect to the second portion 32a.

With the above-described configuration, the connector 200 electrically connects the electrodes (conductive members) having different polarities of the first photoelectric conversion element 10a and the second photoelectric conversion element 10b to each other. The connector 200 may be connected by , for example, soldering or welding at the first connection portion 210 and the second connection portion 220. Preferably, the connector 200 is connected by welding such as, but not limited to, parallel gap resistance welding at the first connection portion 210 and the second connection portion 220. The connector 200 is firmly connected to the first photoelectric conversion element 10a and the second photoelectric conversion element 10b at different positions, that is, at the first connection portion 210 and the second connection portion 220. Therefore, it is possible to provide the photoelectric conversion module 100 capable of connecting the photoelectric conversion elements 10a and 10b with stable connection strength.

The conductive substrate 20b of the second photoelectric conversion element 10b is disposed so as to overlap a part of the collector electrode 30a of the first photoelectric conversion element 10a (see Figs. 1 and 2). Specifically, the conductive substrate 20b of the second photoelectric conversion element 10b may cover at least a part of the second portion 32a of the collector electrode 30a of the first photoelectric conversion element 10a as viewed in the thickness direction (Z direction in the drawing).

The second photoelectric conversion element 10b preferably does not cover the first portion 31a of the collector electrode 30a of the first photoelectric conversion element 10a. As a result, the region of the first photoelectric conversion element 10a exposed from the second photoelectric conversion element 10b increases, so that a wide region where photoelectric conversion can be performed by the first photoelectric conversion element 10a can be secured. Therefore, the photoelectric conversion efficiency of the entire photoelectric conversion module 100 can be improved.

The second photoelectric conversion element 10b covers at least a part, preferably the entire second portion 32a of the collector electrode 30a of the first photoelectric conversion element 10a. More preferably, the second photoelectric conversion element 10b is disposed so as to substantially not cover the first portion 31a while substantially entirely covering the second portion 32a of the collector electrode 30a of the first photoelectric conversion element 10a. As a result, the first photoelectric conversion element 10a and the second photoelectric conversion element 10b can be densely arranged such that a region that does not contribute to photoelectric conversion, that is, a region of the second portion 32a is not exposed. Therefore, the size of the photoelectric conversion module as a whole can be reduced without reducing the efficiency of photoelectric conversion.

The first connection portion 210 of the connector 200 may be provided in a region sandwiched between the first photoelectric conversion element 10a and the second photoelectric conversion element 10b. In other words, the first connection portion 210 of the connector 200 is provided in a region where the first photoelectric conversion element 10a and the second photoelectric conversion element 10b overlap each other as viewed in the thickness direction (Z direction in the drawing). As a result, the first connection portion 210 is provided in a region that does not contribute to photoelectric conversion. Even in this case, the connector 200 may not be connected to the second photoelectric conversion element 10b at the first connection portion 210.

The second connection portion 220 of the connector 200 may be provided in a region overlapping the second photoelectric conversion element 10b as viewed in the thickness direction. As a result, the second connection portion 220 is provided in a region that does not contribute to photoelectric conversion. Furthermore, the second connection portion 220 of the connector 200 is preferably provided at a position not overlapping the first photoelectric conversion element 10a as viewed in the thickness direction. As a result, as will be described later, the connector 200 can be easily connected by the second connection portion 220 at the time of manufacturing the photoelectric conversion module 100.

The connector 200 may have an insulator 230 between the first connection portion 210 and the second connection portion 220 (see Fig. 4). The insulator 230 may be provided on a surface of the connector 200 facing the first photoelectric conversion element 10a. It should be noted that the insulator 230 is provided so as not to hinder conductivity between the first connection portion 210 and the second connection portion 220 of the connector 200.

The insulator 230 may be constituted by, for example, an insulating layer provided on the conductive member 240 constituting the connector 200. In this case, the insulator 230 can be configured, for example, by forming and/or applying an insulating layer on a conductive member constituting the connector 200.

Instead of the above-described aspect, the insulator 230 may be made of, for example, an oxide formed by oxidation of the conductive member 240 constituting the connector 200. Such an insulator 230 can be formed by, for example, oxidizing Al, Ti, Kovar, or the like forming the connector 200. Examples of the oxidation treatment include anodization and oxidation by annealing. As described above, when the insulator 230 is formed by oxidation of the conductive member 240 constituting the connector 200, the insulator 230 may be formed on both surfaces of the connector 200, that is, on both the surface facing the first photoelectric conversion element 10a and the surface facing the second photoelectric conversion element 10b.

The insulator 230 may cover at least one end portion of the first electrode layer 22a of the first photoelectric conversion element 10a and the photoelectric conversion layer 26a of the first photoelectric conversion element 10a, the end portion being located in the region between the first connection portion 210 and the second connection portion 220 when viewed from the thickness direction. Furthermore, the insulator 230 may cover an end portion of the conductive substrate 20a of the first photoelectric conversion element 10a, the end portion being located in a region between the first connection portion 210 and the second connection portion 220 when viewed from the thickness direction.

The end portion of the conductive substrate 20a covered with the insulator 230 may be a region of the conductive substrate 20a exposed from the first electrode layer 22a, the photoelectric conversion layer 26a, or the second electrode layer 24a. The end portion of the first electrode layer 22a covered with the insulator 230 may be a region of the first electrode layer 22a exposed from the photoelectric conversion layer 26a or the second electrode layer 24a. The end portion of the photoelectric conversion layer 26a covered with the insulator 230 may be a region of the photoelectric conversion layer 26a exposed from the second electrode layer 24a.

Fig. 5 is a schematic view for explaining a region of an insulator of the connector. A region R1 illustrated in Fig. 5 indicates a region covered with the insulator 230. As illustrated in Fig. 5, in the first embodiment, the insulator 230 of the connector 200 covers a region opposite to the first portion 31a with respect to the second portion 32a of the collector electrode 30a of the first photoelectric conversion element 10a.

Preferably, the insulator 230 of the connector 200 may extend from one end to the other end of the connector 200 in the Y direction of the drawing along the extending direction of the second portion 32a of the collector electrode 30a of the first photoelectric conversion element 10a.

In the first embodiment, the sizes (areas) of the conductive substrates 20a and 20b and the first electrode layers 22a and 22b are larger than the sizes (areas) of the photoelectric conversion layers 26a and 26b and the second electrode layers 24a and 24b. Therefore, the end portions of the conductive substrates 20a and 20b and the first electrode layers 22a and 22b extend from the photoelectric conversion layers 26a and 26b and the second electrode layers 24a and 24b. In this case, the insulator 230 of the connector 200 may cover, for example, portions of the conductive substrate 20a and the first electrode layer 22a extending from the photoelectric conversion layer 26a and the second electrode layer 24a. Thus, the conductive substrate 20b of the second photoelectric conversion element 10b can be prevented from electrically contacting the first electrode layer 22a and/or the conductive substrate 20a of the first photoelectric conversion element 10a. Similarly, when the insulator 230 covers the region of the photoelectric conversion layer 26a exposed from the second electrode layer 24a, the conductive substrate 20b of the second photoelectric conversion element 10b can be prevented from electrically contacting the photoelectric conversion layer 26a of the first photoelectric conversion element 10a. Therefore, an electrical short circuit between the first photoelectric conversion element 10a and the second photoelectric conversion element 10b can be suppressed.

Instead of the illustrated aspect, the sizes (areas) of the conductive substrate 20a and the first electrode layer 22a may be substantially the same as the sizes (areas) of the photoelectric conversion layer 26a and the second electrode layer 24a. Even in this case, the outer edges of the conductive substrate 20a, the first electrode layer 22a, and the photoelectric conversion layer 26a are exposed on the side surface of the first photoelectric conversion element 10a. In this case, the insulator 230 of the connector 200 may cover the outer edge portions of the conductive substrate 20a, the first electrode layer 22a, and the photoelectric conversion layer 26a when viewed from the thickness direction. Even in this case, the conductive substrate 20b of the second photoelectric conversion element 10b can be prevented from electrically contacting the first electrode layer 22a, the conductive substrate 20a, and/or the photoelectric conversion layer 26a of the first photoelectric conversion element 10a.

The configurations of the connection portions of the two photoelectric conversion elements 10a and 10b adjacent to each other and the vicinity thereof have been described above. The configuration related to the connection may be applied between arbitrary photoelectric conversion elements adjacent to each other.

The photoelectric conversion module 100 including the plurality of photoelectric conversion elements 10a and 10b may have a sealing material (not illustrated). The sealing material may be provided to seal the whole of the plurality of photoelectric conversion elements 10a and 10b or the conductive substrates 20a and 20b of the plurality of photoelectric conversion elements 10a and 10b having the above-described configuration. Furthermore, the photoelectric conversion module 100 may have a support substrate (not illustrated) that supports the entire plurality of photoelectric conversion elements 10a and 10b including the sealing material.

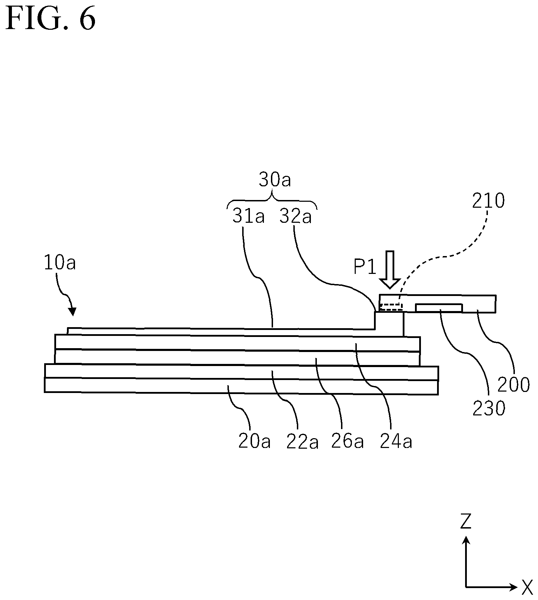

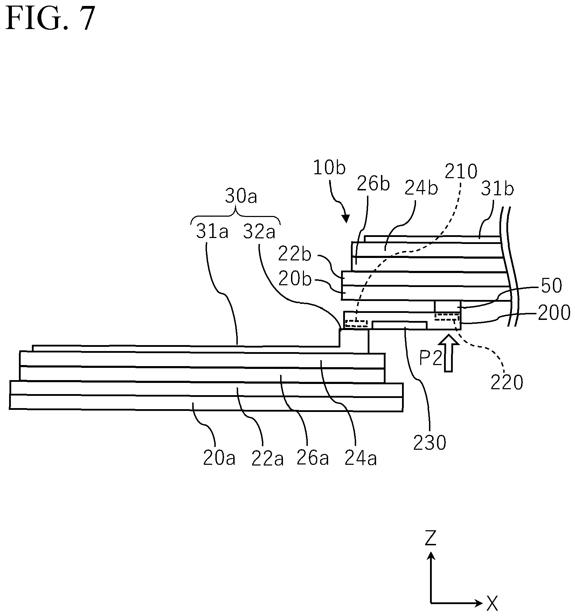

Next, a method for manufacturing the photoelectric conversion module 100 according to the first embodiment will be described with reference to Figs. 6 and 7. Fig. 6 is a schematic view for explaining one step in the method for manufacturing the photoelectric conversion module. Fig. 7 is a schematic view for describing a step subsequent to the step illustrated in Fig. 6.

First, the first photoelectric conversion element 10a and the second photoelectric conversion element 10b each including the first electrode layers 22a and 22b, the second electrode layers 24a and 24b, and the photoelectric conversion layers 26a and 26b between the first electrode layers 22a and 22b and the second electrode layers 24a and 24b, and the connector 200 are prepared. The first photoelectric conversion element 10a, the second photoelectric conversion element 10b, and the connector 200 may have the above-described structure.

In the manufacturing process of each of the photoelectric conversion elements 10a and 10b, the first electrode layers 22a and 22b, the first buffer layer not shown, the photoelectric conversion layers 26a and 26b, the second buffer layer not shown, and the second electrode layers 24a and 24b are formed on the conductive substrates 20a and 20b. In addition, if necessary, a metal material such as molybdenum, titanium or chromium may be formed on the back side of the conductive substrates 20a and 20b in order to prevent warpage. The first buffer layer and the second buffer layer may be formed if necessary.

The first electrode layers 22a and 22b are formed by depositing a material constituting the first electrode layers 22a and 22b on the surfaces of the conductive substrates 20a and 20b, for example, by a sputtering method. The materials constituting the first electrode layers 22a and 22b are as described above. The sputtering method may be a direct current (DC) sputtering method or a radio frequency (RF) sputtering method. In addition, the first electrode layers 22a and 22b may be formed using a chemical vapor deposition (CVD) method, an atomic layer deposition (ALD) method, or the like instead of the sputtering method.

The photoelectric conversion layers 26a and 26b are formed on the first electrode layers 22a and 22b by deposition. In a specific example, the photoelectric conversion layers 26a and 26b are formed, for example, by forming a thin film precursor layer on the first electrode layers 22a and 22b and by chalcogenizing the precursor layer.

The second buffer layer is formed on the photoelectric conversion layer 26a, 26b by a method such as a chemical bath deposition (CBD) method, a sputtering method, a CVD method or an ALD method. The material constituting the second buffer layer is as described above.

The second electrode layers 24a and 24b are formed on the second buffer layer by a method such as a sputtering method, a CVD method or an ALD method. Alternatively, when the second buffer layer is not present, the second electrode layers 24a and 24b are formed on the photoelectric conversion layers 26a and 26b. The materials constituting the second electrode layers 24a and 24b are as described above.

Next, collector electrodes 30a and 30b (first portions 31a and 31b and second portions 32a and 32b) are formed on the second electrode layers 24a and 24b. The collector electrodes 30a and 30b can be formed, for example, by applying a printing process such as an inkjet method or a screen printing method in addition to a sputtering method, a CVD method, an ALD method, an AD method, and a vapor deposition method.

Next, the connector 200 is connected to the second conductive member on the second electrode side of the first photoelectric conversion element 10a at the first connection portion 210. In the first embodiment, the connector 200 is connected to the second portion 32a of the collector electrode 30a of the first photoelectric conversion element 10a at the first connection portion 210 (see the arrow P1 in Fig. 6).

The connector 200 may be welded to the second portion 32a of the collector electrode 30a of the first photoelectric conversion element 10a by, for example, a parallel gap welding method using a resistance welding machine with a transistor control method.

Next, the first photoelectric conversion element 10a and the second photoelectric conversion element 10b are arranged side by side so as to partially overlap each other (see Fig. 7). At this time, the first connection portion 210 of the connector 200 may be covered with the second photoelectric conversion element 10b. In this case, the connector 200 may not be connected to the second photoelectric conversion element 10b at the first connection portion 210. The second connection portion 220, which will be described later, of the connector 200 is located in a region not overlapping the first photoelectric conversion element 10a as viewed in the thickness direction.

Next, the connector 200 is connected to the first conductive member on the first electrode side of the second photoelectric conversion element 10b at the second connection portion 220 away from the first connection portion 210. In the first embodiment, the connector 200 is connected to the connection pad 50 provided on the conductive substrate 20b of the second photoelectric conversion element 10b at the second connection portion 220 (see the arrow P2 in Fig. 7). Note that, as described above, the connection pad 50 may not be provided. In this case, the connector 200 may be directly connected to the conductive substrate 20b of the second photoelectric conversion element 10b at the second connection portion 220.

Here, the second connection portion 220, which will be described later, of the connector 200 is located in a region that does not overlap with the first photoelectric conversion element 10a when viewed from the thickness direction. Therefore, the connector 200 can be easily connected to the conductive substrate 20b of the second photoelectric conversion element 10b without being hindered by the first photoelectric conversion element 10a.

By repeating the above connection step, a large number of photoelectric conversion elements can be coupled side by side with each other.

### [Second Embodiment]

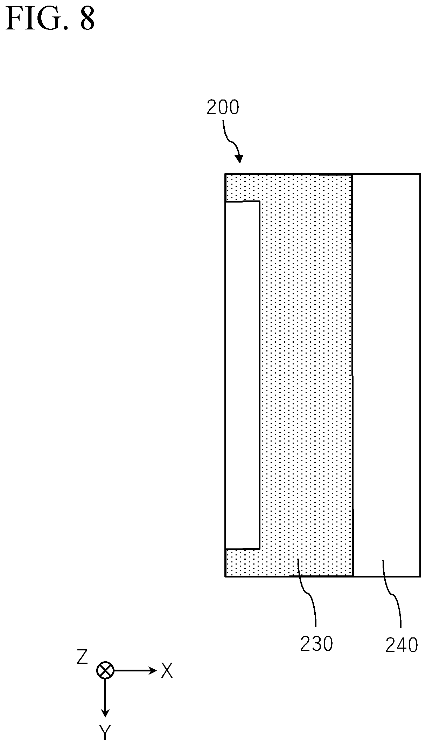

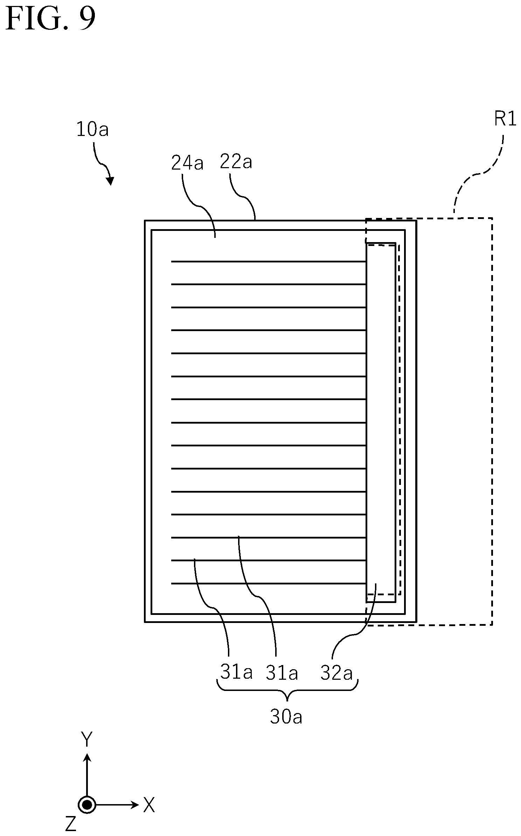

Next, a photoelectric conversion module according to a second embodiment will be described with reference to Figs. 8 and 9. Fig. 8 is a schematic plan view of a connector that connects adjacent photoelectric conversion modules according to the second embodiment. Fig. 8 illustrates one surface of the connector 200 facing the first photoelectric conversion element 10a. Fig. 9 is a schematic view for explaining a region of an insulator of the connector according to the second embodiment. The same components as those of the first embodiment are denoted by the same reference numerals. It should be noted that the description of the same configuration as that of the first embodiment may be omitted.

The second embodiment is different from the first embodiment in a region where the insulator 230 of the connector 200 is provided. In the second embodiment, the insulator 230 has a substantially U-shape defined by a region covered with the second photoelectric conversion element 10b in the end portion of the first photoelectric conversion element 10a.

Specifically, the insulator 230 covers the entire region covered by the second photoelectric conversion element 10b at the end portions of the conductive substrate 20a, the first electrode layer 22a, and the photoelectric conversion layer 26a of the first photoelectric conversion element 10a. Therefore, as illustrated in Fig. 9, the insulator 230 covers a substantially U-shaped region along the periphery of the second portion 32a of the collector electrode 30a of the first photoelectric conversion element 10a in plan view.

This makes it possible to more reliably prevent the conductive substrate 20a, the first electrode layer 22a, and/or the photoelectric conversion layer 26a of the first photoelectric conversion element 10 from coming into contact with the conductive substrate 20b of the second photoelectric conversion element 10b.

The other configurations and the method for manufacturing the photoelectric conversion module are similar to those of the first embodiment, and thus the description thereof will be omitted.

### [Third Embodiment]

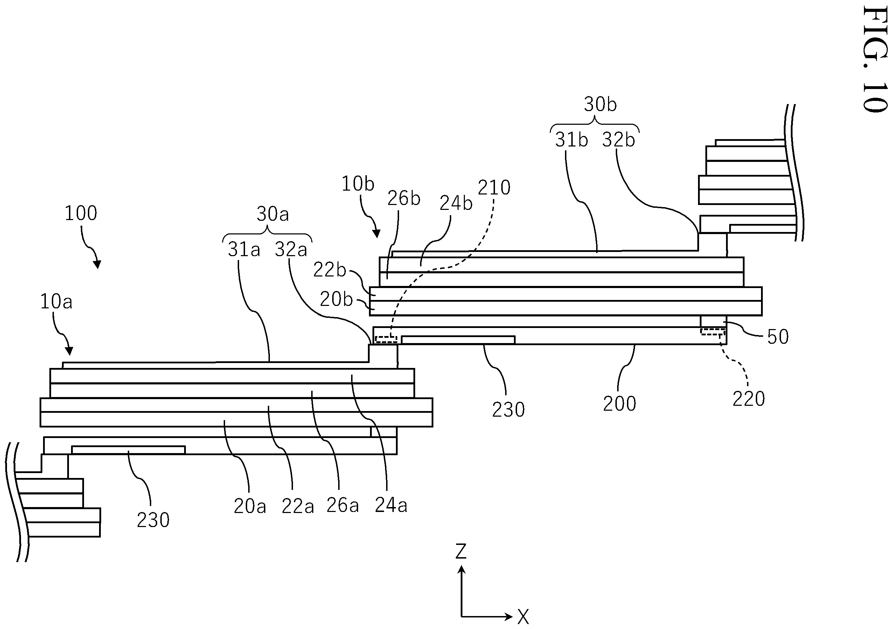

Next, a photoelectric conversion module according to a third embodiment will be described with reference to Fig. 10. Fig. 10 is a schematic side view of the photoelectric conversion module according to the third embodiment. The same reference numerals are given to the same configurations as those of the first embodiment and the second embodiment. It should be noted that description of configurations similar to those of the first embodiment and the second embodiment may be omitted.

The third embodiment is different from the first embodiment in the position of the second connection portion 220 of the connector 200. In the third embodiment, the second connection portion 220 of the connector 200 is provided in a region that does not contribute to photoelectric conversion in the second photoelectric conversion element 10b as viewed in the thickness direction. Here, the region of the second photoelectric conversion element 10b that does not contribute to photoelectric conversion may be, for example, a region covered by the collector electrode 30b, a region covered by a photoelectric conversion element (an element on a side opposite to the first photoelectric conversion element 10a) adjacent to the second photoelectric conversion element 10b, and/or a region where the photoelectric conversion layer 26b does not exist at an end portion of the second photoelectric conversion element 10b.

In a specific example, the connector 200 extends to a position overlapping the second portion 32b of the collector electrode 30b of the second photoelectric conversion element 10b when viewed from the thickness direction in the arrangement direction in which the first photoelectric conversion element 10a and the second photoelectric conversion element 10b are arranged. The second connection portion 220 of the connector 200 is provided at a position overlapping the second portion 32b of the collector electrode 30b of the second photoelectric conversion element 10b when viewed from the thickness direction. It should be noted that a position overlapping the second portion 32b of the collector electrode 30b of the second photoelectric conversion element 10b when viewed from the thickness direction corresponds to a region that does not contribute to photoelectric conversion.

When the energy supplied for the connection of the connector 200, for example, the energy supplied by welding is increased, the photoelectric conversion layer 26b may be damaged. According to the above configuration, the region of the photoelectric conversion layer 26b that may be damaged due to the connection in the second connection portion 220 of the connector 200 corresponds to a region that does not contribute to photoelectric conversion in the second photoelectric conversion element 10b. Therefore, it is possible to suppress the possibility that the region contributing to photoelectric conversion in the photoelectric conversion layer 26b is damaged at the time of connecting the connector 200, and it is possible to suppress a decrease in photoelectric conversion efficiency.

The other configurations and the method for manufacturing the photoelectric conversion module are similar to those of the first embodiment, and thus the description thereof will be omitted.

### [Fourth Embodiment]

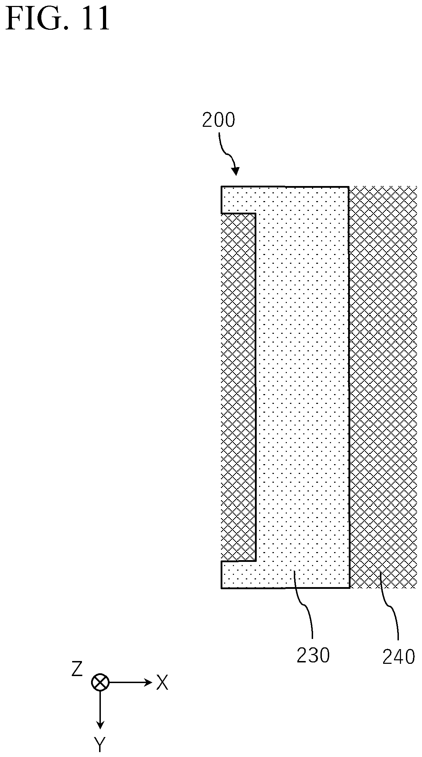

Next, a photoelectric conversion module according to a fourth embodiment will be described with reference to Fig. 11. Fig. 11 is a schematic plan view of a connector included in the photoelectric conversion module according to the fourth embodiment. Fig. 11 illustrates a surface of the connector facing the first photoelectric conversion element 10a.

In the fourth embodiment, the connector 200 includes a mesh-like conductive member 240. When the conductive member 240 constituting the connector 200 has a mesh shape, the area of the conductive member 240 is reduced. Therefore, damage to the photoelectric conversion layers 26a and 26b due to connection at the time of forming the first connection portion 210 and the second connection portion 220 can be suppressed.

Also in the fourth embodiment, the connector 200 preferably includes the insulator 230 as described above. The other configurations and the method for manufacturing the photoelectric conversion module are similar to those of the first embodiment, and thus the description thereof will be omitted.

### [Fifth Embodiment]

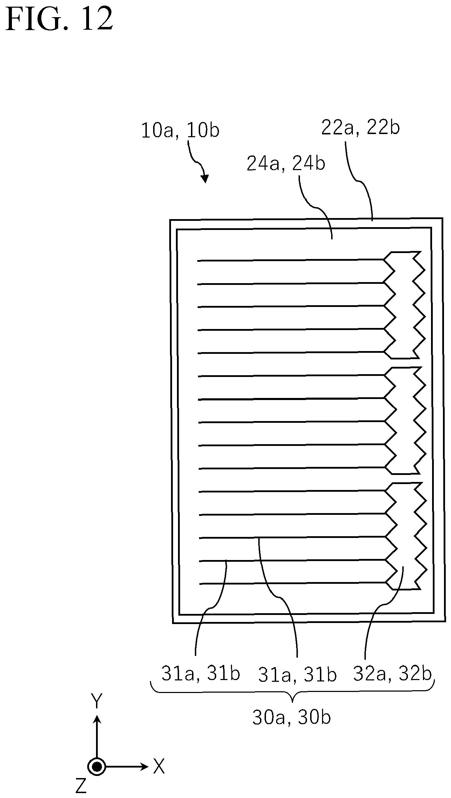

Next, a photoelectric conversion module according to a fifth embodiment will be described with reference to Fig. 12. Fig. 12 is a schematic plan view of each photoelectric conversion element constituting the photoelectric conversion module according to the fifth embodiment. The same reference numerals are given to the same configurations as those of the first to fourth embodiments. It should be noted that description of configurations similar to those of the first to fourth embodiments may be omitted.

In the fifth embodiment, the collector electrodes 30a and 30b of the first photoelectric conversion element 10a and the second photoelectric conversion element 10b have a plurality of substantially linear first portions 31a and 31b and second portions 32a and 32b connected to the plurality of first portions 31a and 31b.

In the fifth embodiment, the second portions 32a and 32b of the collector electrodes 30a and 30b are divided into a plurality of sections (see Fig. 12). Specifically, the second portions 32a and 32b of the collector electrodes 30a and 30b are divided into sections corresponding to some of the first portions 31a and 31b. In this case, the connector 200 is preferably connected to all of the second portions 32a and 32b divided into a plurality of sections. In this case, as compared with the case where the second portions 32a and 32b of the collector electrodes 30a and 30b are continuously connected and extend, thermal damage due to the connection of the connector 200 can be reduced. Here, since the second portions 32a and 32b of the collector electrodes 30a and 30b are divided into several sections, stress due to heat at the time of connection or at the time of use is also dispersed in each section. Therefore, stress due to heat at the time of connection or use can be alleviated, and breakage, peeling, and the like of the connector 200 can be suppressed.

In the fifth embodiment, the second portions 32a and 32b of the collector electrodes 30a and 30b are not linear but extend in a zigzag shape. As described above, the second portions 32a and 32b of the collector electrodes 30a and 30b may extend in a bent or curved manner.

### [Sixth Embodiment]

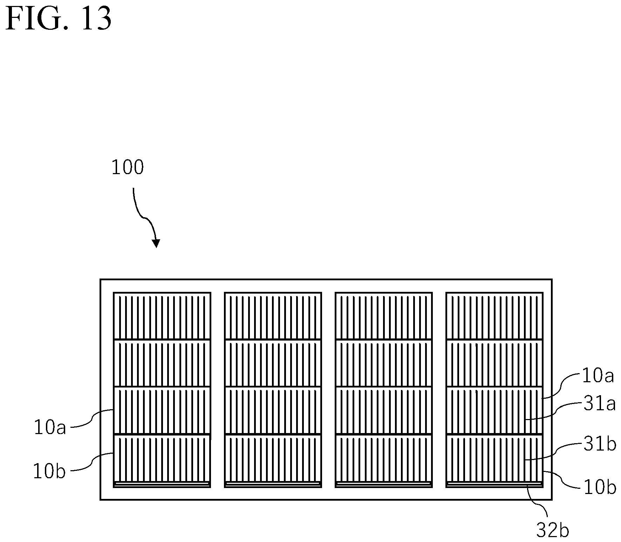

Next, a photoelectric conversion module according to a sixth embodiment will be described with reference to Fig. 13. Fig. 13 is a schematic plan view of a photoelectric conversion module according to a sixth embodiment. The same reference numerals are given to the same configurations as those of the first embodiment. It should be noted that the description of the same configuration as that of the first embodiment may be omitted.

The photoelectric conversion module 100 may include one or a plurality of photoelectric conversion elements 10a and 10b. Note that Fig. 13 illustrates the photoelectric conversion module 100 including the plurality of photoelectric conversion elements 10a and 10b. The one or more photoelectric conversion elements 10a and 10b may be sealed with, for example, a sealing material.

When the photoelectric conversion module 100 includes the plurality of photoelectric conversion elements 10a and 10b, the plurality of photoelectric conversion elements 10a and 10b may be arranged in at least one direction, and preferably may be arranged in a lattice pattern. In this case, the plurality of photoelectric conversion elements 10a and 10b may be electrically connected to each other in series and/or in parallel.

In the example illustrated in Fig. 13, among the photoelectric conversion elements 10a and 10b arranged in one direction, adjacent photoelectric conversion elements partially overlap each other. Specifically, as illustrated in Fig. 13, the second photoelectric conversion element 10b may be disposed so as to cover the second portion 32a of the collector electrode 30a of the first photoelectric conversion element 10a adjacent thereto. In this case, the second photoelectric conversion element 10b is electrically connected to the second portion 32a of the collector electrode 30a of the first photoelectric conversion element 10a adjacent thereto.

The photoelectric conversion elements 10a and 10b adjacent to each other may be electrically connected to each other by the connector 200 described above. In this case, the connector 200 may extend across the photoelectric conversion elements 10a and 10b adjacent to each other.

Instead of the aspect illustrated in Fig. 13, the photoelectric conversion elements 10a and 10b adjacent to each other may be arranged at intervals.

### [Artificial Satellite and Paddle for Artificial Satellite]

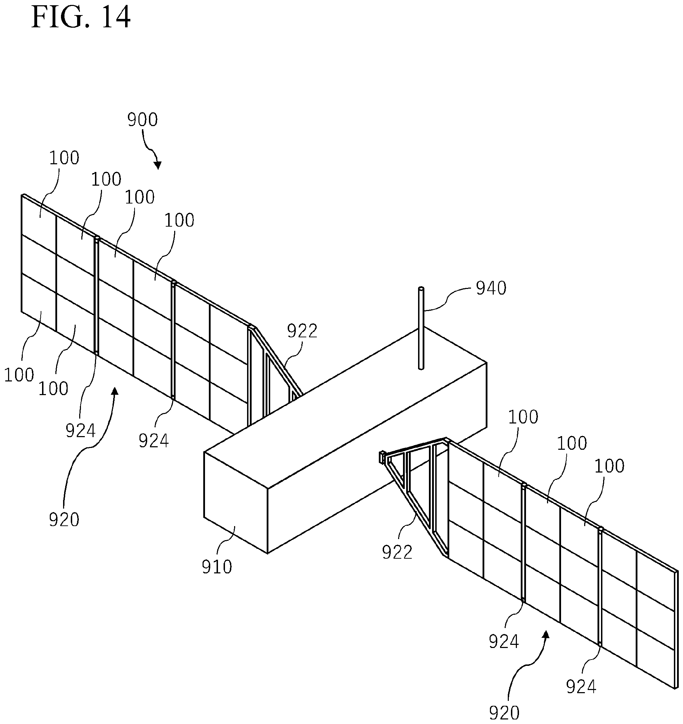

Next, an artificial satellite including a photoelectric conversion module and a paddle for an artificial satellite will be described. Fig. 14 is a schematic perspective view of an artificial satellite including a photoelectric conversion module. An artificial satellite 900 may have a base portion 910 and a paddle 920. The base portion 910 may include a device (not illustrated) necessary for controlling the artificial satellite 900 and the like. An antenna 940 may be attached to the base portion 910.

The paddle 920 may include the photoelectric conversion module 100 described above. The paddle 920 including the photoelectric conversion module 100 can be used as a power source for operating various devices provided in the base portion 910. As described above, the photoelectric conversion module 100 can be applied to a paddle for an artificial satellite. In particular, since the paddle 920 for an artificial satellite is exposed to a high temperature environment and a severe temperature change environment at the time of launching and operating the artificial satellite, it is desirable to use the photoelectric conversion module 100 including the photoelectric conversion element 10a, 10b having high heat resistance described above.

The paddle 920 may include a connecting portion 922 and a hinge portion 924. The connecting portion 922 corresponds to a portion connecting the paddle 920 to the base portion 910.

The hinge portion 924 extends along one direction, and the paddle 920 can be bent with the hinge portion 924 as a rotation axis. Each paddle 920 may have at least one, preferably a plurality of, hinge portions 924. Thus, the paddle 920 including the photoelectric conversion module 100 is configured to be small and foldable. When the artificial satellite 900 is launched, the paddle 920 may be in a folded state. The paddle 920 may be deployed when receiving sunlight to generate power.

Instead of the structure as illustrated in Fig. 14, the paddle 920 may have a cylindrical shape formed by being wound. Accordingly, the paddle 920 can take a substantially flat developed state by the rotation of the wound portion. When the artificial satellite 900 is launched, the paddle 920 may maintain a generally cylindrical shape. The paddle 920 may be unfolded in a substantially flat state when receiving sunlight to generate power.

As described above, the contents of the present invention have been disclosed through the embodiments, but it should not be understood that the description and the drawings constituting a part of the disclosure limit the present invention. From this disclosure, various alternative embodiments, examples, and operational techniques will become apparent to those skilled in the art. Therefore, the technical scope of the present invention is defined only by the matters specifying the invention according to the claims appropriate from the above description.

Each feature described in each of the foregoing embodiments may be applied to or replaced with another embodiment as much as possible. In the above embodiment, the thin-film photoelectric conversion element has been described as an example, but the present invention is not limited thereto, and can be applied to a crystalline photoelectric conversion element as much as possible.

In the embodiment described above, the connector 200 is connected to the second portion 32a of the collector electrode 30a of the first photoelectric conversion element 10a at the first connection portion 210. Alternatively, the connector 200 may be directly connected to the second electrode layer 24a of the first photoelectric conversion element 10a at the first connection portion 210, or may be connected to a connection pad provided on the second electrode layer 24a.

In the embodiment described above, one connector 200 connects the first photoelectric conversion element 10a and the second photoelectric conversion element 10b. Alternatively, the first photoelectric conversion element 10a and the second photoelectric conversion element 10b may be connected to each other by a plurality of connectors 200. In this case, the connector 200 may be constituted by elongated members arranged in parallel with each other.

In the above-described embodiment, a so-called CIS-based thin-film photoelectric conversion element has been described as an example of the photoelectric conversion elements 10a and 10b. It should be noted that the present invention is not limited thereto, and can also be applied to a crystalline photoelectric conversion element containing silicon.

This application claims priority based on Japanese Patent Application No. 2021-177691 filed on October 29, 2021, the entire contents of which are incorporated herein by reference.

## Claims

1. A photoelectric conversion module comprising:
a first photoelectric conversion element;
a second photoelectric conversion element; and
a connector, wherein
the first photoelectric conversion element and the second photoelectric conversion element are arranged side by side so as to partially overlap each other,
the connector is connected to the first photoelectric conversion element at a first connection portion, and
the connector is connected to the second photoelectric conversion element at a second connection portion away from the first connection portion.

2. The photoelectric conversion module according to claim 1, wherein the first connection portion is provided in a region between the first photoelectric conversion element and the second photoelectric conversion element, and
the second connection portion is provided at a position not overlapping the first photoelectric conversion element as viewed in a thickness direction.

3. The photoelectric conversion module according to claim 1 or 2, wherein the first photoelectric conversion element includes a collector electrode, and
the connector is connected to the collector electrode or a connection pad provided on the collector electrode.

4. The photoelectric conversion module according to claim 3, wherein the collector electrode of the first photoelectric conversion element has a plurality of substantially linear first portions and a second portion connected to the plurality of first portions, and
the second portion is divided into a plurality of sections.

5. The photoelectric conversion module according to any one of claims 1 to 4, wherein the second photoelectric conversion element includes a conductive substrate, and
the connector is connected to the conductive substrate or a connection pad provided on the conductive substrate.

6. The photoelectric conversion module according to any one of claims 1 to 5, wherein the second connection portion of the connector is provided in a region that does not contribute to photoelectric conversion in the second photoelectric conversion element as viewed in a thickness direction.

7. The photoelectric conversion module according to any one of claims 1 to 6, wherein the connector includes an insulator between the first connection portion and the second connection portion.

8. The photoelectric conversion module according to claim 7, wherein
the first photoelectric conversion element includes:
a first electrode layer;
a second electrode layer; and
a photoelectric conversion layer between the first electrode layer and the second electrode layer, and
the insulator covers at least one end portion of the first electrode layer of the first photoelectric conversion element and the photoelectric conversion layer of the first photoelectric conversion element, said end portion being located in a region between the first connection portion and the second connection portion when viewed from a thickness direction.

9. The photoelectric conversion module according to claim 7 or 8, wherein the first photoelectric conversion element includes a conductive substrate connected to the first electrode layer of the first photoelectric conversion element, and
the insulator covers an end portion of the conductive substrate of the first photoelectric conversion element, the end portion being located in a region between the first connection portion and the second connection portion as viewed in a thickness direction.

10. The photoelectric conversion module according to any one of claims 7 to 9, wherein the insulator has a U-shape defined by a region covered with the second photoelectric conversion element in an end portion of the first photoelectric conversion element.

11. The photoelectric conversion module according to any one of claims 1 to 10, wherein the connector includes a mesh-like conductive member.

12. A method for manufacturing a photoelectric conversion module, the method comprising:
a step of preparing a first photoelectric conversion element, a second photoelectric conversion element, and a connector;
a step of connecting the connector to the first photoelectric conversion element at a first connection portion;
a step of arranging the first photoelectric conversion element and the second photoelectric conversion element side by side so as to partially overlap each other; and
a step of connecting the connector to the second photoelectric conversion element at a second connection portion away from the first connection portion.

13. A paddle comprising the photoelectric conversion module according to any one of claims 1 to 11.
